Europäisches Patentamt

European Patent Office

Office européen des brevets

(19)

(11)  EP 0 911 088 A2

(12)  EUROPÄISCHE PATENTANMELDUNG

(43) Veröffentlichungstag:
28.04.1999  Patentblatt 1999/17

(51) Int. Cl.$^6$: **B05D 3/06**

(21) Anmeldenummer: 98119873.2

(22) Anmeldetag: 20.10.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 21.10.1997 DE 19746388
23.06.1998 DE 19827900

(71) Anmelder: Roche Diagnostics GmbH
68305 Mannheim-Waldhof (DE)

(72) Erfinder:
Effenberger, Franz Prof. Dr.
70597 Stuttgart (DE)

(74) Vertreter:
Weiss, Wolfgang, Dipl.-Chem. Dr. et al
Patentanwälte
Weickmann & Partner,
Kopernikusstrasse 9
81679 München (DE)

(54)  **Verfahren zur Beschichtung von Oberflächen**

(57)  Die Erfindung betrifft ein Verfahren zur
Beschichtung einer metallischen oder halbmetallischen
Oberfläche, wobei man reaktive Gruppen enthaltende
Beschichtungsmoleküle durch Bestrahlung mit Licht
kovalent an die Oberfläche bindet, sowie eine strukturiert beschichtete Oberfläche.

EP 0 911 088 A2

**Beschreibung**

Die Erfindung betrifft ein neues Verfahren zur Beschichtung einer metallischen oder halbmetallischen Oberfläche sowie eine strukturiert beschichtete Oberfläche.

Durch Beschichtung können Oberflächen funktionalisiert werden, um dadurch vorbestimmte und wünschenswerte Eigenschaften zu erzielen. Die kovalente Beschichtung von Siliciumoberflächen mit organischen Molekülen über eine Kohlenstoff-Silicium-Bindung ist bekannt (M.R. Linford et al., J. Am. Chem. Soc. 115 (1993), 12631-12632; M.R. Linford et al., J. Am. Chem. Soc. 117 (1995), 3145-3155). Diese Beschichtungen wurden durch Umsetzung von Wasserstoff-terminiertem Si (111) mit 1-Alkenen über einen radikalischen Mechanismus unter Verwendung von Diacylperoxiden als Radikalstarter hergestellt. Die Verwendung von Peroxiden ist jedoch nachteilig, da Peroxide äußerst reaktiv, gesundheitsschädlich und außerdem in ihrer Reaktivität wenig spezifisch sind.

Weiterhin ist es bekannt, selbstassemblierende Monoschichten von funktionalisierten Organosilylverbindungen auf hydroxylierten Siliciumoberflächen zu bilden (F. Effenberger et al., Synthesis 1995, 1126-1130; K. Bierbaum et al., Langmuir 11 (1995), 512-518; S.Heid et al., Langmuir 12 (1996), 2118-2120; P. Harder et al., Langmuir 13 (1997), 445-454). In EP-A-0 664 452 wird die kovalente Bindung von Kieselsäureverbindungen an die OH-Gruppen einer oxidierten Siliciumoberfläche beschrieben. Nachteilig bei diesen Verfahren ist jedoch, daß die Oberfläche vor der Beschichtung chemisch vorbehandelt werden muß und zudem unerwünschte Vernetzungsreaktionen stattfinden können. Darüber hinaus ist es für viele Anwendungen vorteilhaft, wenn die Beschichtung auf einer metallischen und nicht auf einer oxidierten Oberfläche aufgebracht ist.

Der vorliegenden Erfindung lag deshalb die Aufgabe zugrunde, ein Verfahren zur Beschichtung von metallischen Oberflächen bereitzustellen, welches die im Stand der Technik auftretenden Nachteile nicht aufweist.

Die Aufgabe wird erfindungsgemäß gelöst durch ein Verfahren zur Beschichtung einer metallischen oder halbmetallischen Oberfläche, welches dadurch gekennzeichnet ist, daß man Beschichtungsmoleküle, die reaktive Gruppen enthalten, durch Bestrahlung mit Licht kovalent an die Oberfläche bindet.

Überraschenderweise wurde festgestellt, daß durch die Aktivierung mit Licht eine effiziente Beschichtung von metallischen oder halbmetallischen Oberflächen mit reaktive Gruppen enthaltenden Molekülen erhalten werden kann. Die Bezeichnung "reaktive Gruppe" bedeutet im Zusammenhang mit der vorliegenden Erfindung, daß unter geeigneten Bedingungen und bei Bestrahlung mit Licht geeigneter Wellenlänge eine kovalente Bindung der reaktiven Gruppe an eine Oberfläche erfolgt.

Die Bindung der Beschichtungsmoleküle an die Oberfläche kann auf einer direkten Photoaktivierung von reaktiven Gruppen in den Beschichtungsmolekülen beruhen. Weiterhin kann die Bindung auch durch Photoaktivierung der Oberfläche selbst erfolgen, wenn diese reaktive, z.B. durch Licht aktivierbare Gruppen, z.B. Metall- oder/und Halbmetallhydridverbindungen wie etwa Siliciumhydrid, enthält. Die durch Licht aktivierten Gruppen der Oberfläche sind dann in der Lage, kovalente Bindungen mit reaktiven Gruppen der Beschichtungsmoleküle einzugehen. Auch eine Kombination beider Reaktionsmechanismen, d.h. Photoaktivierung der Beschichtungsmoleküle und Photoaktivierung der Oberfläche, ist möglich.

Die zu beschichtenden Oberflächen weisen einen metallischen oder halbmetallischen Charakter auf und können ein oder mehrere Metalle, Halbmetalle oder/und metallische bzw. halbmetallische Verbindungen umfassen. Beispiele für geeignete Elemente, die eine metallische oder halbmetallische Oberfläche bilden, sind die Metalle und Halbmetalle der Gruppen 3 bis 16 des Periodensystems. Besonders bevorzugte Beispiele sind Silicium, Germanium und metallische Verbindungen, die diese Elemente enthalten. Beispiele für Oberflächen, die mehr als ein Element umfassen, sind Legierungen, die zwei oder mehr Metalle oder/und Halbmetalle umfassen. Ein Beispiel für eine Verbindung, die einen metallischen Charakter aufweist, ist Galliumarsenid. Besonders bevorzugt ist die Oberfläche eine hydrierte Oberfläche, d.h. die Metall- oder/und Halbmetallatome der Oberflächenschicht sind zumindest teilweise an Wasserstoff gebunden. Ein Beispiel für ein Metall- bzw. Halbmetallhydrid ist Siliciumhydrid. Bei den erfindungsgemäß verwendeten metallischen Oberflächen handelt es sich insbesondere um Oberflächen, die nichtoxidierte Elemente bzw. Verbindungen aufweisen.

Erfindungsgemäß werden die reaktive Gruppen enthaltenden Moleküle an die metallische oder halbmetallische Oberfläche kovalent, beispielsweise über eine Oberflächenelement-Kohlenstoff- oder Oberflächenelement-Sauerstoff-Bindung gebunden. Die verwendeten Moleküle können dabei grundsätzlich eine beliebige reaktive Gruppe umfassen, d.h. eine Gruppe, die durch Bestrahlung mit Licht direkt oder/und aufgrund von Wechselwirkungen mit der Oberfläche in eine reaktive Spezies, insbesondere in ein Radikal, überführt werden kann. Bevorzugt wird die reaktive Gruppe aus C = C- oder C = O-Doppelbindungen ausgewählt. Beispiele für solche reaktive Gruppen sind Alken-, Aldehyd- und Vinylethergruppen. Besonders bevorzugt sind Aldehydgruppen, mit denen überraschend hohe Bedeckungsgrade erhalten werden können. Bei Aldehydgruppen erfolgt die Bindung an die Oberfläche über den Sauerstoff. Im Gegensatz zu bekannten Beschichtungsverfahren an hydroxylierte Siliciumoberflächen, bei denen die Dicke der $SiO_2$ Schicht unbestimmt ist, können mit dem erfindungsgemäßen Verfahren vorbestimmte, definierte und gleichmäßige Beschichtungen erhalten werden.

2

Bei der Verwendung von Alkengruppen werden die Beschichtungsmoleküle über ein Kohlenstoffatom an die Oberfläche gebunden.

Durch das erfindungsgemäße Verfahren werden beschichtete metallische oder halbmetallische Oberflächen hergestellt, die für eine Vielzahl von Anwendungen geeignet sind, z.B. zur Herstellung mikroelektronischer Bauteile, sowie für Anwendungen in der Diagnostik und der Medizin. Anwendungen für funktionalisierte Oberflächen, die durch chemische Kopplung von Beschichtungsmolekülen an die Oberfläche hergestellt wurden, sind z.B. in WO 92/10092, Fodor et al. (Nature 364 (1993), 555-556) und Cheng und Stevens (Adv. Mater. 9 (1997), 481-483) beschrieben. Für diese Anwendungen sind auch erfindungsgemäßdurch Photoaktivierung beschichtete Oberflächen geeignet.

Hierzu werden für die Beschichtung zweckmäßigerweise Moleküle verwendet, die neben einer oder mehreren reaktiven Gruppen mindestens eine weitere funktionelle Gruppe enthalten. Die weitere funktionelle Gruppe wird bevorzugt ausgewählt aus Haptenen, Biotin, Chelatierungsgruppen, Nukleotiden, Nukleinsäuren, Nukleinsäurenanaloga, Polyethylenglykol, konjugierten $\pi$-Systemen, geladenen Gruppen, nichtlinearen optischen Stukturen, vernetzbaren Gruppen, elektrisch leitfähigen Gruppen, Aminosäuren, Peptiden und Polypeptiden.

Für Anwendungen in der Mikroelektronik können Moleküle verwendet werden, die konjugierte $\pi$-Systeme umfassen. Gerade bei solchen Verbindungen ist die im Stand der Technik bekannte Aktivierung mit Peroxiden nachteilig, da das Auftreten unerwünschter radikalischer Nebenreaktionen beobachtet wird. Durchdieerfindungsgemäße Bestrahlung mit Licht definierter Wellenlänge, ist es hingegen möglich, selektiv diejenigen reaktiven Gruppen, die zur Bindung an die metallische Oberfläche vorgesehen sind, zu aktivieren und gleichzeitig weitere Gruppen, z.B. $\pi$-Bindungen oder konjugierte $\pi$-Bindungen im Molekül nicht zu beeinflussen. Bevorzugt werden als konjugierte $\pi$-Systeme enthaltende organische Moleküle Polyene, Aromaten, z.B. Polyphenylene, Heterocyclen, z.B. Polyheteroaryle und/oder Polyacetylene verwendet.

Durch vernetzbare Gruppen, wie beispielsweise Doppelbindungen, z.B. Acrylester oder/und Dreifachbindungen, kann die Beschichtung nach dem Aufbringen auf die metallische oder halbmetallische Oberfläche vernetzt werden. Eine Vernetzung kann auch über eine Oxidation erfolgen, z. B. von schwefelhaltigen Gruppen wie etwa Thiol- oder Thiophengruppen.

Durch die Verwendung von Haptenen, Polypeptiden und/oder Biotin können spezifisch bindefähige Festphasen gebildet werden, die beispielsweise in diagnostischen Verfahren, z. B. Immunoassays, eingesetzt werden können.

Bei Beschichtung der Oberfläche mit Nukleotiden, Nukleinsäuren oder Nukleinsäureanaloga wie etwa peptidischen Nukleinsäuren, werden Oberflächen erhalten, die beispielsweise für Nukleinsäure-Hybridisierungstests geeignet sind.

Durch die Verwendung von Polyethylenglykol oder anderer inerter Moleküle können chemisch inerte und resistente Oberflächen sowie biokompatible Oberflächen, z.B. zur Verwendung als Implantatoberflächen hergestellt werden.

Elektrisch leitfähige Gruppe und bestimmte Polypeptide, wie z.B. Bakteriorhodopsin eignen sich insbesondere für elektronische Anwendungen.

Die weiteren funktionellen Gruppen können während der Bindung der organischen Moleküle an die Oberfläche gegebenenfalls durch Schutzgruppen blockiert werden. Eine solche Blockierung ist jedoch oftmals nicht erforderlich, wenn die zur Photoaktivierung verwendete Wellenlänge so gewählt werden kann, daß zwar die photoaktivierbare Gruppe aktiviert wird, die weitere funktionelle Gruppe jedoch beim Wellenlängenbereich des eingestrahlten Lichtes nicht reagiert.

Bevorzugt wird eine metallische oder halbmetallische Oberfläche verwendet, die mindestens ein Element ausgewählt aus B, Al, Ga, Si, Ge und As umfasst. Besonders bevorzugt wird als Oberfläche eine Siliciumhydridoberfläche verwendet. Eine solche Oberfläche kann beispielsweise durch Ätzen von oxidiertem Si-(111) mit Ammoniumfluorid hergestellt werden (G. J. Pietsch, Appl. Phys. A: Mater. Sci. Process. A 60 (1995) 367-363; G. J. Pietsch, Struktur und Chemie technologischer Siliciumoberflächen, VDI Fortschrittsberichte Reihe 9, 148, VDI-Verlag, Düsseldorf 1992).

Die Beschichtung wird bevorzugt in einer Inertgasatmosphäre durchgeführt, beispielsweise unter Argon.

Die im erfindungsgemäßen Verfahren zur Bestrahlung verwendete Lichtquelle muß eine genügende Intensität aufweisen, um eine ausreichende Beschichtungseffizienz zu erzielen. Grundsätzlich ist für die Beschichtung jede Art von Lichtquelle geeignet, z.B. Lampen wie etwa eine HBO-Lampe. Als besonders günstig hat sich jedoch die Verwendung von Lasern erwiesen. Vorzugsweise ist die Lichtquelle in der Lage, Licht einer definierten Wellenlänge oder eines definierten Wellenlängenbereiches einzustrahlen. Dies kann durch Verwendung monochromatischer Lichtquellen wie etwa eines Lasers oder entsprechender Filter erreicht werden. Bei Verwendung von monochromatischem Licht oder eines Lichts mit einem engen definierten Wellenlängenbereich gelingt es auf selektive Weise, die photoaktivierbaren Gruppen der Beschichtungsmoleküle oder/und der Oberfläche anzuregen, während andere in den Beschichtungsmolekülen enthaltene funktionelle Gruppen nicht beeinflußt werden.

Bevorzugt verwendet man Licht mit einer Wellenlänge im Bereich von 350 bis 400 nm, insbesondere von 370 bis 395 nm. Besonders bevorzugt wird Licht mit einer Wellenlänge im Bereich von 380 bis 390 nm eingestrahlt.

Die Bestrahlungsdauer- und intensität hängt vom gewünschten Bedeckungsgrad, der verwendeten metallischen oder halbmetallischen Oberfläche, den verwendeten Beschichtungsmolekülen und den Reaktionsbedingungen ab. Üblicherweise erhält man die gewünschten Ergebnisse bei Bestrahlung über einen Zeitraum von 1 Minute bis 30 Stunden.

Durch das erfindungsgemäße Verfahren wird eine über den Beschichtungsbereich lateral homogene Schicht an Beschichtungsmolekülen, vorzugsweise eine Monoschicht, erzeugt. Dabei kann eine einzige Spezies von Beschichtungsmolekülen aber auch ein Gemisch mehrerer Spezies von Beschichtungsmolekülen eingesetzt werden. In einer bevorzugten Ausführungsform des erfindungsgemäßen Verfahrens wird ein Gemisch unterschiedlicher Beschichtungsmoleküle eingesetzt, wobei eine Spezies der Beschichtungsmoleküle eine spezifisch mit einem freien Reaktionspartner bindefähige Gruppe, z.B. Biotin, Hapten, Polypeptid, Nukleinsäure etc., enthält, während eine andere Spezies der Beschichtungsmoleküle keine derartige funktionelle Gruppe enthält und somit als "Verdünnungsmolekül" wirkt. Das molare Verhältnis von funktionellen Beschichtungsmolekülen zu Verdünnungsmolekülen ist vorzugsweise von 1:100 bis 100:1.

Ein wesentlicher Vorteil des erfindungsgemäßen Verfahrens liegt darin, daß es möglich ist, selektiv und präzise bestimmte Bereiche einer Oberfläche zu beschichten. Beispielsweise durch die Verwendung einer geeigneten Optik oder durch die Verwendung von Lasertechnik kann eine metallische oder halbmetallische Oberfläche selektiv in kleinsten räumlichen Bereichen bis in den Mikrometerbereich beschichtet werden. So können etwa Beschichtungsmoleküle, die elektrisch leitfähige Gruppen enthalten, an gewünschten Orten durch Bestrahlung aufgebracht werden, so daß ein in der Mikroelektronik verwendbarer Schaltkreis entsteht. Selbstverständlich ist es auch möglich, eine Oberfläche großflächig zu beschichten. Neben der Verwendung von Lasern und/oder einer fokussierenden Optik, kann eine strukturierte Beschichtung auch durch die Verwendung von Masken oder/und optischen Gittern aufgebracht werden. Auf diese Weise ist es möglich, beschichtete metallische Oberflächen mit beliebigen, vorbestimmten Mustern zu erzeugen. Das erfindungsgemäße Verfahren ist insbesondere zur Herstellung von Array-Strukturen geeignet, die beispielsweise in der Diagnostik zur Herstellung von Biosensoren verwendet werden können.

Durch Aufbringen von Molekülen, die spezifisch bindefähige Gruppen aufweisen, wie etwa Haptene, Biotine, Nukleobasen, Nukleinsäuren, Nukleinsäureanaloga, Polypeptide u.ä., kann man beschichtete Oberflächen für die Diagnostik herstellen. Durch Verwendung von biokompatiblen organischen Molekülen ist es möglich, Oberflächen, die aus einem Material bestehen, welches an sich vom Körper abgestoßen wird, bioverträglich zu machen.

Ein weiterer Gegenstand der Erfindung ist ein beschichteter Gegenstand, umfassend einen Träger mit einer metallischen oder halbmetallischen Oberfläche und daran kovalent gebundenen Beschichtungsmoleküle, welcher dadurch gekennzeichnet ist, daß die Oberfläche eine Anordnung beschichteter und unbeschichteter Bereiche aufweist. Vorzugsweise sind die beschichteten Bereiche miniaturisiert, d.h. sie haben eine Fläche von 1 $\mu m^2$ bis 10 $mm^2$, besonders bevorzugt von 10 $\mu m^2$ bis 1 $mm^2$. Im Gegensatz von im Stand der Technik bekannten Verfahren zur Beschichtung metallischer Oberflächen durch chemische Aktivierung, bei denen lediglich eine vollflächige Beschichtung möglich war, kann mit dem erfindungsgemäßen Verfahren eine strukturiert beschichtete Oberfläche erhalten werden. Es ist eine Oberfläche mit definiertem Beschichtungsmuster herstellbar, bei der die Beschichtung nur in vorbestimmten Bereichen der Oberfläche aufgebracht ist. Bevorzugt weist die Oberfläche eine Array-Struktur auf. Durch geeignete Fokussierungsoptiken und/oder Lasertechniken ist es möglich, präzise, örtlich abgegrenzte Bereiche selektiv zu beschichten. Die Oberfläche umfaßt bevorzugt Beschichtungsmoleküle, die mindestens eine weitere funktionelle Gruppe enthalten, oder Mischungen von funktionellen Beschichtungsmolekülen mit inerten Verdünnungsmolekülen. Je nach Anwendung können entsprechend geeignete funktionelle Gruppen wie zuvor beschrieben eingesetzt werden.

Die Erfindung wird durch die beigefügten Figuren und die nachfolgenden Beispiele weiter erläutert.

Figur 1     zeigt die Verbindungen 1 bis 3, die zur Beschichtung von Metalloberflächen eingesetzt wurden. Bei den Verbindungen 1a, 1b und 1c handelt es sich um Alkene, bei der Verbindung 2 um einen Vinylether und bei den Verbindungen 3a und 3b jeweils um einen Aldehyd.

Figur 2     zeigt schematisch die Bildung einer Schicht von Octadecanal 3a auf einer H-terminierten Si-(111) Oberfläche.

Figur 3     zeigt die Abhängigkeit des Bedeckungsgrads einer Tetradecanal-Schicht auf einer Si-Oberfläche von der eingestrahlten Wellenlänge.

Figur 4     zeigt die Abhängigkeit des Bedeckungsgrades einer Octadecen-Schicht auf einer Si-Oberfläche von der eingestrahlten Wellenlänge.

EP 0 911 088 A2

**Beispiele**

**Beispiel 1 Beschichtung einer H-terminierten Siliciumoberfläche mit Alkenen und Vinylethern**

Eine Si-H-Oberfläche wurde durch Ätzen von oxidierten Si(111)-Wafern mit Ammoniumfluorid nach bekannten Methoden hergestellt (G. J. Pietsch, Appl. Phys. A: Mater. Sci. Process. A 60 (1995) 347-363; G. J. Pietsch, Struktur und Chemie technologischer Siliciumoberflächen, VDI-Fortschrittsberichte, Reihe 9, 148, VDI-Verlag, Düsseldorf 1992). Die Siliciumwafer (Si(111)p-Typ) wurden von der Wacker-Chemitronic GmbH und Siltronix bezogen.

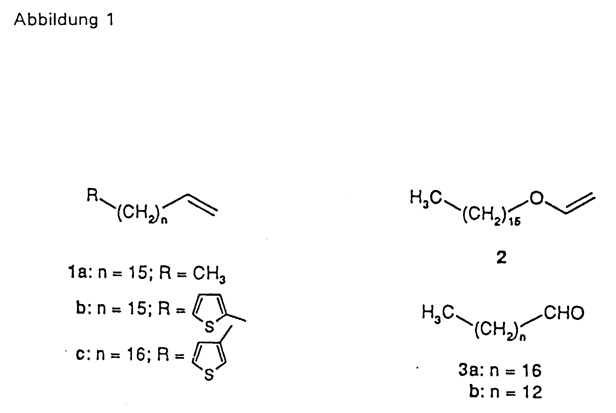

Die mit Fluoridionen geätzte H-terminierte Siliciumoberfläche wurde zu den reinen Verbindungen 1, 2 bzw. 3 (vgl. Fig. 1) in einer Glasküvette gegeben und für 20 bis 24 h in einer Inertgasatmosphäre bestrahlt. Unter den hier verwendeten Versuchsbedingungen wurde ein optimale Reaktionszeit von 20 bis 24h festgestellt, wobei kürzere oder längere Reaktionszeiten in einer verringerten Bedeckung resultierten. Die Bildung von selbstassemblierenden Monoschichten wurde durch Einstrahlen einer HBO-Lampe (150 W) initiiert. Dann wurde das Siliciumsubstrat entnommen, mehrere Male mit Dichlormethan gespült und mit Baumwolle abgewischt, um physikalisch adsorbiertes Material zu entfernen.

Zum Vergleich wurde die Bildung von Monoschichten mit 1-Octadecen (1a) auf einer H-terminierten Si(111)-Oberfläche durch Dioctadecanoylperoxid gemäß dem Stand der Technik initiiert (M. R. Linford et al., J. Am. Chem. Soc. 117 (1995), 3145-3155). Die Ergebnisse sind in Tabelle 1 dargestellt.

Tabelle 1

| Reaktanten | Reaktionszeit (Stunden) | Temperatur (°C) | $V_{as}$ (CH$_2$) (cm$^{-1}$) | Bedeckung (%) [a] | Kontaktwinkel $\Theta_a$(H$_2$O) (Grad) |
|---|---|---|---|---|---|
| [C$_{17}$H$_{35}$C(O)O]$_2$ | 1,5 | 100 | 2918,7 | 50,5 | 91 |
| [C$_{17}$H$_{35}$C[O]O]$_2$/ **1a** (1:1) | 1,0 | 102 | 2918,6 | 57 | 96 |
| [C$_{17}$H$_{35}$C(O)O]$_2$/ **1a** (1:9) | 1,5 | 101,0 | 2920,0 | 48 | 91 |
| OTS | 15 | 20 | 2917,7 | 100 | 106 |
| 1a | 24 | 20-50 [b] | 2920,5 | 55 | 95 |
| 1a [c] | 20 | 20-50 [b] | 2922,4 | 21 | - |
| 1b | 13 | 20-50 [b] | 2920,0 | 40 | - |
| 1c | 20 | 20-50 [b] | 2921,6 | 29 | - |
| 2 | 20 | 30 | 2921,0 | 45 | 80 |

[a] bezogen auf Octadecyltrichlorsilan (OTS)-Filme mit 100 % Bedeckung
[b] während der Bestrahlung erhöhte sich die Temperatur auf 50°C.
[c] Verdünnung Verbindung 1a: Hexadecan im Verhältnis 9:1.

Wie aus Tabelle 1 ersichtlich ist, können mit dem erfindungsgemäßen Verfahren etwa gleiche Beschichtungsgrade für Alkene erzielt werden, wie mit dem im Stand der Technik bekannten Verfahren unter Verwendung von Peroxiden, wobei jedoch auf diese gefährlichen und unspezifischen chemischen Reagenzien verzichtet werden kann.

Die Oberflächenbedeckung wurde unter Verwendung von Gleichung 1:

$$y = 0,007 \cdot x - 0,03429 \quad (x = \text{die Anzahl an CH}_2 \text{ Gruppen})$$

berechnet, die von einer linearen Regressionsanalyse der Diagrammflächen der $v_{as}$(CH$_2$) und $v_s$(CH$_2$) Banden von sieben Alkyltrichlorsilanen (Waferdaten) in Abhängigkeit ihrer Kettenlänge (8, 10, 12, 14, 16, 18 und 20 CH$_2$ Gruppen) erhalten wurde (S. Heit et al., Langmuir 12 (1996) 2118-2120). Die Bedeckung wird durch Dividieren der Flächen der Banden von $v_{as}$(CH$_2$) und $v_s$(CH$_2$) durch y erhalten.

Neben dem terminal nichtsubstituierten 1-Alken 1a wurde die Monoschichtbildung auch mit den reinen ω-Thienyl-substituierten 1-Alkenen 1b und c sowie mit dem Hexadecylvinylether 2 durch Bestrahlung unter vergleichbaren Bedingungen untersucht. Darüber hinaus wurde festgestellt, daß selbst eine geringe Verdünnung der 1-Alkene mit einem Alkan als Lösungsmittel die Bildung der selbstassemblierenden Monoschicht deutlich beeinflußt, was in einer geringeren Bedeckung resultiert. Die Verwendung eines Gemisches umfassend neun Teile der Verbindung 1a und ein Teil Hexadecan weist beispielsweise einen Bedeckungsgrad von nur 20% auf.

5

**Beispiel 2 Beschichtung einer H-terminierten Siliciumoberfläche mit Aldehyden**

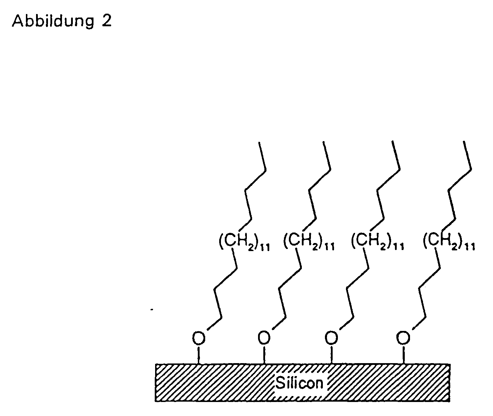

Der in Beispiel 1 beschriebene Versuch wurde unter den gleichen Bedingungen wie für die Verbindung 1a beschrieben durchgeführt, außer daß als Beschichtungsmolekül reines 1-Octadecanal (3a) (R. Redcliff et al., J. Org. Chem. 35 (1970), 4000-4002) verwendet wurde. Durch hochauflösende AFM-Abbildungen ($50x50nm^2$) wurde festgestellt, daß eine homogene selbstassemblierende Monoschicht mit einem hohen Bedeckungsgrad von 97% bezogen auf 100% Bedeckung mit Octadecyltrichlorsilan (OTS) erhalten wird. In Figur 2 ist schematisch eine Monoschicht der Verbindung 3a dargestellt. Aus dem dichroistisch Verhältnis D = 0,54 kann ein mittlerer Neigungswinkel von 12° für die Moleküle in der Monoschicht gegenüber dem Substrat abgeleitet werden (A. Ulman, An Introduction to Ultrathin Organic Films, Academic Press, London 1991). Dieses Ergebnis stimmt mit den Literaturdaten von OTS-Filmen (M. R. Linford et al., J) Am. Chem. Soc. 117 (1995) 3145-3155) überein.

**Beispiel 3 Bildung einer selbstassemblierenden Monoschicht unter Verwendung verschiedener Wellenlängen**

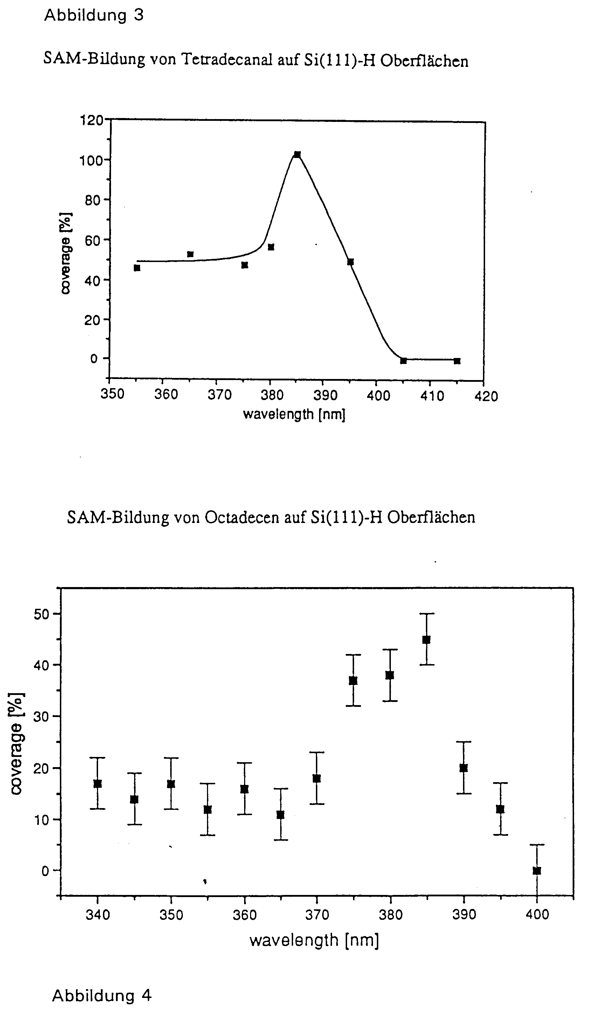

Reines Tetradecanal (Verbindung 3b) wurde wie in Beispiel 1 beschrieben, auf eine Si(111)-H-Oberfläche bei 40°C bei verschiedenen Strahlungswellenlängen aufgebracht. Als Lichtquelle wurde bei diesem Versuch eine XBO-Lampe (450 W) und ein Doppelmonochromator (Jarrell Ash Co. mod. 82-440) mit 1,3 nm Halbwertsbreite verwendet. Die Ergebnisse sind in Tabelle 2 und Abbildung 3 zusammengefaßt.

Tabelle 2

| Wellenlänge (nm) | Bestrahlungsdauer (h) | $v_{as}(CH_2)$ (cm$^{-1}$) | Fläche $v_s$ und $v_{as}$ ($CH_2$) | Bedeckungsgrad (%) [a] |
|---|---|---|---|---|
| 355 | 15,5 | 2922 | 0,0297 | 46 |
| 365 | 16,5 | 2925 | 0,03468 | 53 |
| 375 | 16,8 | 2922 | 0,03069 | 48 |
| 380 | 14,8 | 2921 | 0,03652 | 57 |
| 385 | 16,4 | 2920 | 0,0656 | 103 |
| 395 | 16,0 | 2922 | 0,03207 | 50 |
| 405 | 14,5 | - | - | 0 |
| 415 | 15,0 | - | - | 0 |

[a] Bezogen auf OTS-Filme mit 100% Bedeckung

Wie aus Tabelle 2 und Abbildung 3 ersichtlich ist, wurde der maximale Bedeckungsgrad mit Licht einer Wellenlänge von 385 nm erhalten.
Analog wurde die Abhängigkeit des Bedeckungsgrades von der Wellenlänge mit reinem Octadecen (Verbindung 1a) untersucht. Auch hier wurde eine maximale Bedeckung bei 385 nm erhalten (vgl. Abbildung 4).

**Beispiel 4 Bildung einer selbstassemblierenden Monoschicht von Aldehyden in Abhängigkeit von der Bestrahlungszeit.**

Die Geschwindigkeit der Bildung von selbstassemblierenden Monoschichten wurde mit reinem Octadecanal (Verbindung 3a) auf einer Si(111)-H-Oberfläche untersucht. Der Einfluß der Bestrahlungsdauer auf Bedeckungsgrad und Orientierung der gebildeten Monoschichten ist in Tabelle 3 zusammengefaßt.

Tabelle 3

| Bestrahlungsdauer (min) | $v_{as}(CH_2)$ $(cm^{-2})$ | Fläche $v_s$ und $v_{as}$ $(CH_2)$ | Bedeckungsgrad (%) [a] |
|---|---|---|---|
| 1 | 2922 | 0,0357 | 39 |
| 3 | 2918 | 0,0746 | 82 |
| 5 | 2917 | 0,0943 | 103 |
| 30 | 2916 | 0,0975 | 106 |
| 60 | 2916 | 0,0978 | 107 |
| 120 | 2916 | 0,0833 | 91 |

[a] Bezogen auf OTS-Filme mit einem Bedeckungsgrad von 100%.

Die wie in Beispiel 1 hergestellte H-terminierte Si-Oberfläche wurde in reines Octadecanal (Verbindung 3a) in eine Glasküvette gegeben. Sie wurde auf 70°C erwärmt und für die in Tabelle 3 angegebenen Zeitdauern mit polychromatischem Licht bestrahlt. Die Oberfläche wurde entnommen und wie in Beispiel 1 beschreiben gereinigt.

Nach einer Minute Bestrahlungsdauer wurde ein Bedeckungsgrad von 39% festgestellt und die Lage der $v_{as}(CH_2)$-Bande bei 2922 $cm^{-1}$ zeigt eine geringe Ordnung der Monoschicht an. Der Bedeckungsgrad war nach 3 Minuten Bestrahlung auf 80% erhöht. Bereits mit einer Bestrahlungszeit von 5 Minuten konnte ein optimaler Bedeckungsgrad von 103% erhalten werden. Die $v_{as}(CH_2)$-Bande bei 2917 $cm^{-1}$ zeigt die Bildung einer perfekt geordneten selbstassemblierenden Monoschicht der Verbindung 3a an.

**Beispiel 5 Herstellung von lateral strukturierten beschichteten Oberflächen**

Bei bisherigen Untersuchungen zum Aufbau von Self-Assembly-Monoschichten (Ulman, Chem. Rev. 96 (1996), 1533-1554 und weitere Literaturzitate darin; Xia und Whitesides, Angew. Chem. Int. Ed. Engl. 37 (1998), 550-575; Effenberger und Heid, Synthesis 1995, 1126-1130; Bierbaum et al., Langmuir 11 (1995), 512-518; Heid et al., Langmuir 12 (1996), 2118-2120; Harder et al., Langmuir 13 (1997), 445-454) war eine direkte laterale Strukturierung der Oberflächen nicht möglich, da man von chemisch einheitlichen Oberflächen ausging und die anschließende chemische Reaktion mit den schichtbildenden Substraten ebenfalls einheitlich erfolgte.

Die erfindungsgemäße lichtinduzierte Herstellung von Self-Assembly-Monoschichten ermöglicht jedoch bei Verwendung geeigneter Masken eine direkte Strukturierung von Oberflächen. Als Masken besonders geeignet sind dabei Folien, die bei der Herstellung von Platinen verwendet werden.

Die Strukturen der Masken wurden mit dem Computerprogramm Freehand 5.0 gezeichnet und direkt mit einem lasergestützten Photosatzsystem (Linotronic 530, Linotype-Hell, Auflösung 2540 Dots/Zoll) auf Polymerfolien (Fuji Laserrecorderfilm F100) gedruckt. Dann wurde das SiH-Substrat mit der Maske bedeckt, Octadecanal zugegeben und geschmolzen. Die Monoschichtbildung und -reinigung erfolgten wie zuvor beschrieben.

Anhand von IR-Spektren konnte nachgewiesen werden, daß bei Abdeckung eines Teils der Si (111)-H-Oberfläche nur der nichtabgedeckte Bereich eine SAM-Schicht ergibt. Darüber hinaus wurde festgestellt, daß der nichtbelichtete Teil der SiH-Oberfläche noch voll reaktiv ist.

Aufgrund der unterschiedlichen Benetzbarkeit des beschichteten bzw. unbeschichteten Siliciums läßt sich die Strukturierung der Siliciumoberfläche auch für eine Betrachtung mit bloßem Auge bzw. im Mikroskop sichtbar machen. Hierzu wurde das mit einer strukturierten Beschichtung versehene Substrat unter einem Mikroskop (Carl Zeiss, zwanzigfache Vergrößerung) mit einigen Tropfen einer Mischung aus 2-Propanol und Universalöl (Lubricant Consult GmbH) benetzt. Das nach einigen Sekunden ausgebildete Muster wurde photographiert.

**Patentansprüche**

1. Verfahren zur Beschichtung einer metallischen oder halbmetallischen Oberfläche,
   **dadurch gekennzeichnet**,
   daß man Beschichtungsmoleküle, die reaktive Gruppen enthalten, durch Bestrahlung mit Licht kovalent an die Oberfläche bindet.

2. Verfahren nach Anspruch 1,
   **dadurch gekennzeichnet**,

daß die Bindung der Beschichtungsmoleküle an die Oberfläche über

    (a) eine Photoaktivierung von reaktiven Gruppen in den Beschichtungsmolekülen,
    (b) eine Photoaktivierung von reaktiven Gruppen auf der Oberfläche oder
    (c) eine Kombination von (a) und (b) erfolgt.

3. Verfahren nach Anspruch 1 oder 2,
   **dadurch gekennzeichnet**,
   daß die Beschichtungsmoleküle neben reaktiven Gruppen mindestens eine weitere funktionelle Gruppe enthalten.

4. Verfahren nach einem der vorhergehenden Ansprüche,
   **dadurch gekennzeichnet**,
   daß die Oberfläche mindestens ein Element ausgewählt aus B, Al, Ga, Si, Ge und As umfaßt.

5. Verfahren nach einem der vorhergehenden Ansprüche,
   **dadurch gekennzeichnet**,
   daß die Oberfläche mindestens eine Metall- oder/und Halbmetallhydridverbindung umfaßt.

6. Verfahren nach einem der vorhergehenden Ansprüche,
   **dadurch gekennzeichnet**,
   daß man ein Gemisch von unterschiedlichen Spezies von Beschichtungsmolekülen verwendet.

7. Verfahren nach einem der vorhergehenden Ansprüche,
   **dadurch gekennzeichnet**,
   daß man eine strukturierte Beschichtung durch Verwendung von Masken oder/und optischen Gittern aufbringt.

8. Verfahren nach einem der vorhergehenden Ansprüche,
   **dadurch gekennzeichnet**,
   daß man eine beschichtete Oberfläche zur Verwendung in der Mikroelektronik herstellt, wobei man Bindemoleküle, die elektrisch leitfähige Gruppen aufweisen, aufbringt.

9. Verfahren nach einem der Ansprüche 1-7,
   **dadurch gekennzeichnet**,
   daß man eine beschichtete Oberfläche für die Diagnostik herstellt, wobei man Bindemoleküle aufbringt, die spezifisch bindefähige Gruppen aufweisen.

10. Verfahren nach einem der Ansprüche 1-7,
    **dadurch gekennzeichnet**,
    daß man eine biokompatible Beschichtung aufbringt.

11. Beschichteter Gegenstand, umfassend einen Träger mit einer metallischen oder halbmetallischen Oberfläche und daran kovalent gebundene Beschichtungsmoleküle,
    **dadurch gekennzeichnet**,
    daß die Oberfläche eine Anordnung beschichteter und unbeschichteter Bereiche aufweist, wobei die beschichteten Bereiche miniaturisiert sind.

Abbildung 1

$R-(CH_2)_n$

1a: n = 15; R = CH₃

b: n = 15; R =

c: n = 16; R =

$H_3C-(CH_2)_{15}-O$

**2**

$H_3C-(CH_2)_n-CHO$

3a: n = 16
b: n = 12

Abbildung 2

Abbildung 3

SAM-Bildung von Tetradecanal auf Si(111)-H Oberflächen

SAM-Bildung von Octadecen auf Si(111)-H Oberflächen

Abbildung 4